# EUROPEAN PATENT APPLICATION

(11) **EP 0 957 586 A1**
(43) Date of publication of application: **17.11.1999**
(21) Application number: 98201623.0
(22) Date of filing: 15.05.1998
(51) Int. Cl.: H03M 7/30, H03M 7/48

(54) **Method for data compression**

(71) Applicant: Algorithmic Research BV., 5674 CC Nuenen (NL)
(72) Inventor: Voermans, Theodorus Sebastiaan, 5665 TA Geldrop (NL); Koekoek, Robert Martin, 5632 MN Eindhoven (NL)
(74) Representative: de Vries, Johannes Hendrik Fokke

(57) **Abstract**

A method for converting and deconverting a data stream is described, wherein the data stream to be converted comprises a stream of [C,S] pairs and the data stream to be deconverted comprises a stream of symbols. The method comprises providing a table of entries [C,Se] and corresponding replacements [C,St], the table entries including one or more [C,S] pairs and the table replacements including one or more [C,St] replacement pairs. The stream of [C,S] pairs is scanned for table entries and one or more [C,S] pairs in the stream are replaced by a corresponding table replacement if a match is found between a table entry and one or more [C,S] pairs in the stream. The stream of symbols is scanned in accordance with a sequence of contexts (C) and a symbol (St) is replaced by the corresponding symbol(s) (S) of the corresponding table entry.

## Description

The invention generally relates to data compression techniques and more specifically to methods and systems to be used in data compression.

Conventional data compression methods can be deemed to be dissected into two parts, i.e. modeling and coding. In the modeling step the input data to be compressed, is read to parse or categorize it. For instance, it can detect a recurring sequence of bytes, or a lower-case English word, a goto instruction, or a blue background in a picture, etc.

The modeling step produces symbols (S) indicating choices made in the parsing/categorization process. In case of lossless data compression, these symbols allow for exact reconstruction of the original data. For example, a particular modeller could transform the input string "An example." into the following stream of symbols:
[UpperCaseWord] [Length2] [a] [n] [LowerCaseWord] [Length7] [e] [x] [a] [m] [p] [l] [e] [Period]

The task of the coding step is to turn these symbols into bits. But, in order to aid the coding step in generating fewer bits, it is very useful to label the symbols in the modeling step with so-called context identifiers or contexts (C). The context of a symbol indicates the 'class' to which the symbol belongs, such as character or word length. In the example above, the coding step encounters twelve different symbols. When tagged with contexts,
[Case,Upper] [Length,2] [char,a] [char,n] [Case,Lower] [Length,7] [char,e] [char,x] [char,a] [char,m] [char,p] [char,l] [char,e] [Punctuation,Period]

the coding step sees four different contexts, with far fewer possible symbols per context. Since it is not necessary to encode the context tags in the coding step, adding context tags inproves compression substantially.

In practical implementations, contexts and symbols are usually represented by numbers, as in the following example corresponding to the stream above:
[0,1] [1,2] [2,1] [2,14] [0,0] [1,7] [2,5] [2,24] [2,1] [2,13] [2,16] [2,12] [2,15] [3,0]

The act of splitting up compression into a modeling and a coding step, interconnected by a (context,symbol) stream, is practiced by virtually all compression algorithms, although simple methods may use a trivial modeling, contexts, and/ or coding step. For a more extensive introduction in data compression see Bell, T.C, Cleary, J.G. and Witten, I.H, "Text Compression", Prentice-Hall 1989.

Many prior art modeling techniques generate a (context,symbol) stream that still contains a large amount of redundancy. That is, the chance on occurrence of a symbol does not depend solely on its accompanying context, but also on following or preceding [context,symbol] or [C,S] pairs.

However, these kinds of dependencies can be very complex and intertwined. An example of such a dependency could be described as "after [0,12] has occurred, [2,7] becomes more likely, until the occurrence of [1,8], unless ... etc." In practice, such dependencies are not limited to adjacent [C,S] pairs, but may stretch long distances. Consequently, many dependencies may overlap. Using conventional methods, simultaneously exploiting the redundancy in thousands of such ad-hoc dependencies easily becomes very complex to manage and too computation intensive for practical use.

The invention aims to provide methods and systems to be used in data compression to improve the compression ratio by exploiting a large class of complex dependencies in (context, symbol) streams.

According to a first aspect of the invention a method for converting and deconverting a data stream is provided, the data stream to be converted comprising a stream of [C,S] pairs and the data stream to be deconverted comprising a stream of symbols, the method of the invention comprising the steps of providing a table of entries [C,Se] and corresponding replacements [C,St], said table entries including one or more [C,S] pairs and said table replacements including one or more [C,St] replacement pairs, scanning said stream of [C,S] pairs for table entries, replacing one or more [C,S] pairs in said stream by a corresponding table replacement if a match is found between a table entry and one or more [C,S] pairs in said stream, scanning said stream of symbols in accordance with a sequence of contexts (C) and replacing a symbol (St) by the corresponding symbol(s) (S) of the corresponding table entry.

Tests have shown that the method of the invention results in an improvement of at least 25% in compression ratio even in comparison with a carefully designed data type specific compression method of the prior art. With a less precise designed compression of the prior art, the improvements will generally be larger. Moreover decompression speed may increase at the cost of a very modest additional compression time.

According to a further aspect of the invention a method for processing a stream of [C,S] pairs is provided, comprising the steps of providing a table of entries [C,Se] and corresponding replacements [C,St], said table entries including one or more [C,S] pairs and said table replacements including one or more [C,St] replacement pairs, scanning said stream of [C,S] pairs for table entries, replacing one or more [C,S] pairs in said stream by a table replacement if a match is found between a table entry and one or more [C,S] pairs in said stream.

According to a still further aspect of the invention a method for processing a stream of symbols is provided, comprising the steps of providing a table of entries [C,S] and corresponding replacements [C,St], said table entries including one or more [C,S] pairs and said table replacements including one or more [C,St] replacement pairs, providing a sequence of contexts (C), scanning said stream of symbols in accordance with the sequence of contexts (C) and replacing a symbol(St) by the corresponding symbol(s) (S) of the corresponding table entry.

Further the invention provides a method for compressing and decompressing data, comprising the steps of modeling the data to obtain a stream of [C,S] pairs, coding [C,S] pairs to obtain compressed data, providing a table of entries [C,Se] and corresponding replacements [C,St], said table entries including one or more [C,Se] pairs and said table replacements including one or more [C,St] replacement pairs, processing the stream of [C,S] pairs provided by said modeling step by scanning said stream for table entries, replacing one or more [C,S] pairs in said stream by a table replacement pair if a match is found between a table entry and one or more [C,S] pairs in said stream, wherein said coding step is carried out on the processed stream of [C,S] pairs, decoding the compressed data to obtain a stream of symbols (S,St), generating a sequence of contexts (C) corresponding to the sequence of contexts provided by said modeling step, providing decoded symbols in accordance with the sequence of contexts, scanning the decoded symbols for table replacement symbols (St) and replacing a table replacement symbol (St) by the symbol(s) (S) of the corresponding table entry.

The invention will be further explained by reference to the drawings in which some embodiments of the invention are schematically shown.
Figure 1 shows a diagram of a compressor/ decompressor implementing a first embodiment of the invention.
Figure 2 shows a diagram of a compressor/ decompressor implementing a second embodiment of the invention.
Figures 3-5 show examples of the contents of a table used in a method of the invention, together with the corresponding original and converted context, symbol streams.
Figure 6 schematically shows a part of the decompressor of Fig. 2 in more detail.
Figure 7 shows a diagram with a number of steps followed by the deconversion step in the decompressor of Fig. 2 to deconvert the converted stream of Fig. 3.
Figure 8 shows by way of example a table used in an embodiment of the invention together with the original and converted context, symbol streams.
Figure 9 shows a diagram with a number of steps followed by the deconversion step in the decompressor of Fig. 2 to deconvert the converted stream of Fig. 8.

In the specification the notation C will be used to denote a context and the notation S will be used to denote a symbol. The notation [C,S] is used to indicate a pair of context, symbol values, i.e. a [C,S] pair. Further the suffix e is used to denote a symbol in a table entry, i.e. Se, whereas the suffix t is used to denote a symbol of a table replacement, i.e. St.

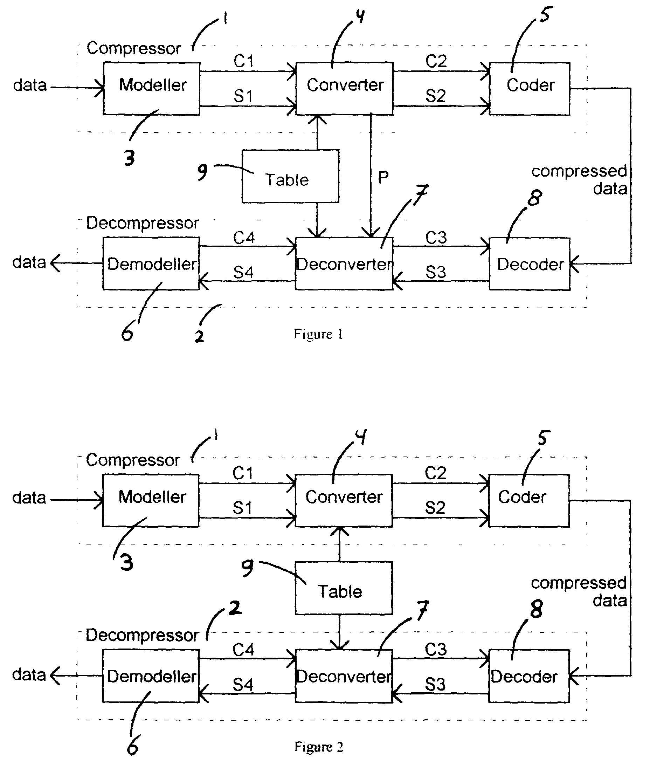

Figure 1 shows a data compression and decompression system including a compressor 1 and a decompressor 2. The compressor 1 comprises a modeller 3, a converter 4 and a coder 5. The decompressor 2 comprises a demodeller 6, a deconverter 7 and a decoder 8. It is noted that the compressor 1 and decompressor 2 generally will be implemented by a PC operating according to a compression and decompression program including an embodiment of the described method of the invention. Further it is noted that existing compression/decompression systems generally include a modeller with coder and a demodeller with decoder as explained in the introduction, i.e. without converter or deconverter, respectively. For a detailed explanation of existing compression/decompression methods reference is made to the above-mentioned book "text compression". As the detailed operation of modeller 3/coder 5 and demodeller 6/decoder 8 is not part of the present invention, a detailed description of modeling/coding and demodeling/decoding will not be given.

As explained in the introduction the modeller 3 operates according to a modeling step providing a stream of [C,S] pairs indicated in Fig. 1 as streams (C1,S1). These streams (C1,S1) contains a large amount of redundancy and to minimize the redundancy in these context, symbol streams (C1,S1) the converter 4 scans the stream of [C,S] pairs in the streams (C1,S1) for specific [C,S] pairs or specific combinations of [C,S] pairs. In order to provide replacement or substitution of [C,S] pairs in the streams (C1,S1) a table is provided in a memory 9. If specific [C,S] pairs or combinations of [C,S] pairs, which are stored in the table 9, are found in the streams (C1,S1), such combinations are replaced by one or more [C,St] replacement pairs resulting in context, symbol streams (C2,S2) provided to the coder 5. This conversion step transforms the streams (C1,S1) into streams (C2,S2) in such a manner that the coder 5 generates a smaller compressed output of compressed data. The stream S2 will contain symbols S and St, for which the notation stream of symbols (S,St) will be used in this specification.

The table 9 comprises a series of entries [C,Se] and corresponding replacements [C,St]. Each table entry includes one or more [C,S] pairs which can be present in the context, symbol streams (C1,S1) and each table replacement includes one ore more [C,St] replacement pairs.

In essence, the proposed conversion method performs substitutions, whereas the deconversion method performs the exact inverse substitutions. This means that streams (C1,S1) equals streams (C4,S4), and streams (C2,S2) equals streams (C3,S3). It is noted that whereas the converter 4 generates streams (C2, S2), deconverter 7 must effect its inverse substitution by emitting streams C3 and S4, as will be explained in more detail hereinafter.

In the embodiment shown the converter 4 and the deconverter 7 are driven by a common table 9. As an alternative the compressor 1 and the decompressor 2 may both carry a local copy of the table 9, or may be arranged to update the table content in sync. The table 9 defines how individual [C,S] pairs or combinations of [C,S] pairs may be substituted for other individual [C,S] pairs or combinations of [C,S] pairs.

In order to exploit a large class of practical dependencies, [C,S] pairs affected by a substitution are not required to be adjacent. For instance, a single substitution may affect two particular [C,S] pairs, located hundreds of positions apart. In the embodiment of Fig. 1 information regarding the position of pairs involved in a substitution is transmitted from the converter 4 to the deconverter 7 as indicated by connection P in fig. 1.

The goal of the substitutions is to reduce the total number of bits generated by compressor 1. Since the method employed by the coder 5 is known, in most practical cases the savings (or cost) of a particular substitution can be easily computed. Alternatively, savings can be approximated by calculating the entropy in (C2,S2) and P, at very low computational cost. In this way, the converter 4 can decide which substitution to perform in order to improve compression.

Figure 2 shows a data compression/decompression system implementing a second embodiment of the invention, which system mainly corresponds to the system shown in Fig. 1, corresponding components being indicated by the same reference numerals. In this embodiment it is not necessary to generate any position information and to provide this position information directly from the converter 4 to the deconverter 7. In this embodiment a large class of practical dependencies can be exploited, wherein still [C,S] pairs affected by a substitution need not to be adjacent. Non-adjacent [C,S] pairs involved in a substitution are addressed implicitly by means of the context information as will be explained hereinafter.

The deconverter 7 described requires very few computational steps per [C,S] pair, while using very little memory. Still, this deconverter 7 is capable of handling large numbers of overlapping substitutions. Therefore, since the number of symbols that need decoding can be sharply reduced, overall decompression speed is bound to increase.

For explanation purposes examples described in this specification will be based on numerical values:
- Contexts will range from 0 to 3 and will be given suffix 'c'.
- Symbols will range from 5 to 12, with suffix 's'.
- Numbers representing table entries will range from 20 to 30, with suffix 't'.
The suffixes are included for purely didactic reasons. In practical implementations the type of a value can be found by performing a simple range test.

The table 9 contains one or more entries (rows), with every entry consisting of a [C,S] pair or a series of [C,S] pairs and a replacement. As mentioned the [C,S] pairs of an entry need not be adjacent in the stream (C1,S1). The replacement is a new [C,St] pair to be inserted into the streams (C1,S1) thereby providing the streams (C2,S2).

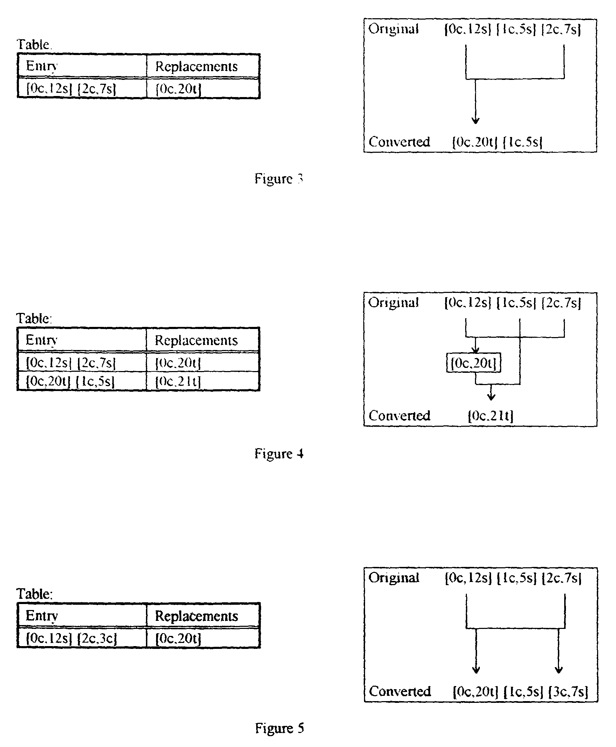

Fig. 3 shows an example of how a table entry allows the converter 4 to convert the streams (C1,S1) into (C2,S2). The converter 4 places [0c,20t] at the original position of the first pair [0c,12s], while [2c,7s] is removed. Symbol 20t is a new symbol (in context 0), which is unknown to the modeller 3 or the demodeller 6. That is, with this type of entry, [C,S] pairs matching the table entry, are replaced by the new [C,St] pair.

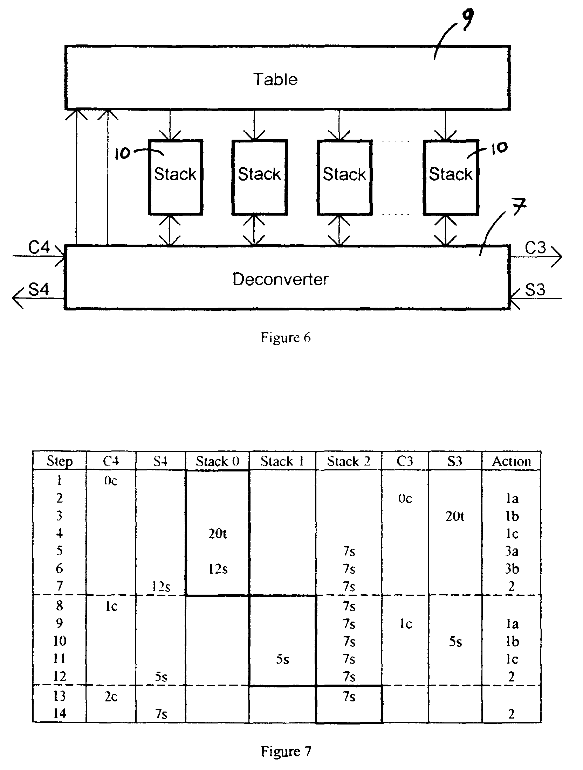

A second type of table entry is shown in fig. 4. According to this example the pairs [0c,12s] and [2c,7s] are replaced by [0c,20t]. Subsequently, [0c,20t] together with [1c,5s] are replaced by [0c,21t]. That is, substitutions can be applied recursively.

Fig. 5 shows a third type of substitution. Note the pair [2c,3c] in the table entry. Both values in this pair are contexts. This pair carries the following meaning: replace the next context 2 after pair [0c,12s] by context 3, but leave the accompanying symbol unchanged. Consequently, in the example the pair [2c,7s] is replaced by the pair [3c,7s]. In a more general way such a pair can be denoted as [Ca,Cb] pair, meaning replace the next context Ca after the corresponding pair of the entry by context Cb.

The converter 4 does not have the obligation to apply substitutions. Sometimes it may skip potential substitutions for the sake of overall compression or efficiency or due to deconverter limitations.

The deconverter 7 uses memory to keep track which substitutions are currently in progress. It has a mechanism to point out which substitutions are currently in progress, which of the pairs in the corresponding table entry is currently being dealt with, and, what action to perform (insert a pair, change a context, pass a pair unchanged).

In the embodiment shown in Fig. 2 a deconverter 7 is used shown in more detail in Fig. 6. The memory used by the deconverter 7 consists of stack memories 10, one stack memory 10 for each context C. These stacks 10 are used to store symbols S that are already decoded, but not yet returned to the demodeller 6.

The deconverter 7 remains idle until it receives a context X, via C4 from the demodeller 6. After receipt of context X , stack memory 10 for context X is designated or addressed as the active stack.

An active stack can be in one of four states:
- State 1:: the active stack is empty.
- State 2:: the top of the active stack contains a symbol valid to the demodeller 6.
- State 3:: the top of the active stack represents a table entry, i.e. a symbol St in case of the deconverter 7.
- State 4:: the top of the active stack contains a context.

The deconverter 7 is programmed in such a manner that actions of the deconverter are determined by the state of the active stack as follows:
- Action 1:: Context X is sent, via C3, to the decoder. The symbol returned via S3 is pushed onto the active stack.
- Action 2:: The symbol is popped off the active stack and sent,via S4, to the demodeller.
- Action 3:: The symbol is popped off the active stack. The corresponding entry is looked up in the table 9. Symbols of the pairs are pushed, in reverse order, onto the corresponding stacks 10. For instance, the table entry having the series [0c,12s] [2c,7s] will cause 7s to be pushed onto stack 2, followed by 12 pushed onto stack 0.
- Action 4:: The context is popped off the active stack and sent, via C3, to the decoder. The symbol returned via S3 is pushed onto the active stack.

The deconverter keeps determining the state of the active stack and performing the corresponding action until a symbol has been returned to the demodeller 7 (via S4).

### Deconverter operation example 1

The diagram of Fig. 7 shows in detail how the converted stream of Fig. 3 is deconverted. The diagram of Fig. 7 lists every change in the deconverter 7, as well as in streams C4,S4,C3,S3. For clarity, most actions are shown as multiple steps (for instance action 1a, 1b, 1c). The area with the thick border line indicates the active stack.

It is first noted that the demodeller 6 generates in a manner known per se a sequence of contexts C corresponding to the sequence of contexts provided by the modeller 3. Each time the demodeller 6 sends a context via C4 to the deconverter 7, after several steps it receives a symbol via S4 from the deconverter 7. Similarly, every time the decoder 8 receives a context via C3 from the deconverter 7, it returns a symbol to the deconverter, via S3. These symbols are obtained by decoding the compressed data in a usual manner.

The deconversion steps will now be described in more detail:
- Step 1:: The demodeller asks for a new symbol in context 0. Stack 0 is now the active stack.
- Step 2-4:: Stack 0 is empty, so the decoder is asked for a new symbol, which is pushed onto stack 0.
- Step 5-6:: The top of stack 0 represents a table entry. The table dictates that 7s must be pushed onto stack 2, followed by 12s onto stack 0.
- Step 7:: Since the top of stack 0 contains a valid symbol (12s), this symbol is returned to the demodeller.
- Step 8:: The demodeller asks for a new symbol in context 1. Stack 1 is now the active stack.
- Step 9-11:: Stack 1 is empty, so the decoder is asked for a new symbol, which is pushed onto stack 1.
- Step 12:: Since the top of stack 1 contains a valid symbol (5s), it is returned to the demodeller.
- Step 13:: The demodeller asks for a new symbol in context 2. Stack 2 is now the active stack.
- Step 14:: Since the top of stack 2 contains a valid symbol (7s), it is returned to the demodeller.

As can be seen, the values in columns C4 and S4 correspond to the pairs in the original streams in fig. 3. It is further noted that the pair [2c,7s] was inserted at the correct location because the deconverter 7 exploits the knowledge of the context asked for by the demodeller.

### Deconverter operation example 2

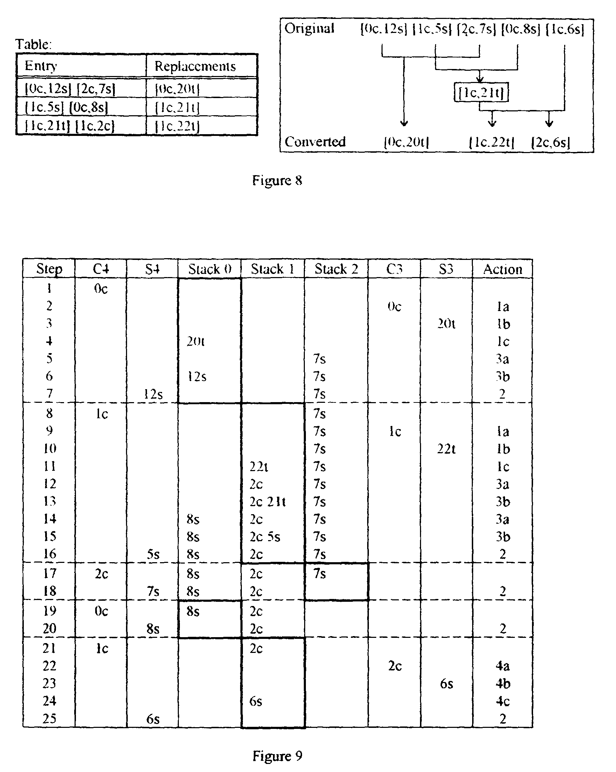

The following example illustrates all three types of replacements, as well as the ability to deal with overlapping substitutions. Fig. 8 shows a table, as well as an original stream being converted accordingly. Note that the third table entry signals a hierarchical substitution (21t), followed by a context substitution (replacing context 1 by context 2).

Fig. 9 shows how the streams (C3,S3) are deconverted to (C4,S4). Stacks are shown with the top of the stack at right. As the operation mainly corresponds to the operation of example 1, only the following steps are explained in detail:
- Step 11:: While the first substitution is not yet completed (7s on stack 2), another substitution is initiated.
- Step 12:: Also contexts can be pushed onto the stack.
- Step 13:: The result of one table lookup (22t in step 11) causes another table lookup (due to 21t).
- Step 21-24:: Since the top of the active stack contains a context (2c), this context is sent to the decoder. The resulting symbol (6s) is pushed back onto the active stack.

It is noted that instead of stack memories, queue memories (with first-in-first-out behaviour) can also be used. The only change in the deconversion method described is that the elements of a table entry are pushed onto the queue memories in the order of the [C,S] pairs and not in the reverse order as with a stack memory, see action 3 mentioned above.

As will be clear from the above explanation, the converter 4 matches [C,S] pairs occurring in the streams (C1,S1) to entries in the table 9. Whenever such a match is found, the converter 4 can perform the corresponding substitution or replacement. However, not all possible (combinations of) substitutions can be handled by the deconverter 7. Therefore, the operation of the converter 4 must be designed in accordance with the operation of the deconverter 7, in particular the operation of its memory stack or queue mechanism.

Regarding designing the converter, it is noted with respect to the embodiments described that the deconverter 7 can only insert a symbol S or replace a context C, when the corresponding replacement of the table entry is on top of an active stack. Therefore, there is no need to scan the streams (C1,S1) for matching [C,S] pairs elsewhere. The converter 4 can determine what value will be on top of an active stack in the deconverter by simply mimicing the stack operation of the deconverter.

If two or more competing potential substitutions, which cannot be applied simultaneously, are encountered during designing the converter, it is possible to calculate or estimate the savings in compressed data size in order to select the best (set of) candidate(s). There is a significant trade-off between computational cost and compression performance.

It will be understood from the above explanation that the main steps in designing a specific converter are: to match, to substitute, to test ability to invert, and to optimize for alternatives.

Creating an optimal table for a given input is - in practical cases - an NP-complete problem. However, very good results can be obtained by repetitively compressing a set of representative sample data while varying the table content, monitoring the compression factor, and retaining the best performing table entries. An excellent method is a brute-force approach where one starts with an empty table, and where an entry rendering the largest improvement is repeatedly added to the table. Due to the following pruning techniques, the task of selecting this 'best' entries (from the huge set of all possible entries) need not be prohibitively time-consuming.

A table entry can only match if all of its pairs match. Therefore, table entries containing rare pairs need not be considered as candidates. For instance, if the pair [3c,14s] occurs only once in the (C1,S1) stream (generated from sample data), this pair need not be considered.

It is noted that the table contents need not be fixed and may be updated during processing. To ensure that compression and decompression are constantly based on the same table, one could send table updates from the compressor to the decompressor explicitly.

Alternatively, one can make such updates implicitly, by applying the same update function in both the compressor and decompressor. In this case, a look-ahead requirement can be avoided by using the streams (C2,S2) and (C3,S3) as input to the update function.

The invention is not restricted to the above-described embodiments which can be varied in a number of ways within the scope of the claims.

## Claims

1. Method for converting and deconverting a data stream, the data stream to be converted comprising a stream of {C,S] pairs, the data stream to be deconverted comprising a stream of symbols (S,St), the method comprising the steps of providing a table of entries [C,Se] and corresponding replacements [C,St], said table entries including one or more [C,S] pairs and said table replacements including one or more [C,St] replacement pairs, scanning said stream of [C,S] pairs for table entries, replacing one or more [C,S] pairs in said stream by a corresponding table replacement if a match is found between a table entry and one or more [C,S] pairs in said stream, scanning said stream of symbols (S,St) in accordance with a sequence of contexts (C) and replacing a symbol (St) by the corresponding symbol(s) (S) of the corresponding table entry.

2. Method according to claim 1, wherein said table is provided with one or more table entries comprising a combination of at least one table replacement pair [C,St] and a [C,S] pair and corresponding replacements [C,St], wherein said stream of [C,S] pairs with replacements is scanned for further table entries.

3. Method according to claim 1 or 2, wherein said table is provided with one or more table entries comprising a combination of a [C,S] pair and a [Ca,Cb] pair and a corresponding replacement [C,St], said [Ca,Cb] pair instructing to replace a next context (Ca) by (Cb).

4. Method according to claim 1, 2 or 3, wherein position information is generated for each replacement made in the stream of [C,S] pairs, wherein a symbol (St) is replaced by the correponding symbol(s) (S) at a location in the stream of symbols as indicated by said position information.

5. Method according to claim 1, 2 or 3, wherein the sequence of contexts (C) is used to address a number of memories, each memory corresponding with a predetermined context (C), wherein for each context of said sequence the corresponding memory is read, wherein
a) if a symbol is not available from the corresponding memory, a next symbol is read from the stream of symbols and loaded into the corresponding memory,
b) if a symbol (S) is available in the corresponding memory, said symbol is inserted delivered to a symbol output, and
c) if a symbol (St) is available in the corresponding memory, the table is read for the corresponding table entry and the symbol(s) (S) of this entry are loaded in the memories in accordance with the corresponding context(s) of said entry.

6. Method according to claim 5, wherein, if a context (Cb) is available in the memory read as addressed by a context (C), a symbol is read from the stream of symbols (S) and loaded into the same memory.

7. Method for processing a stream of [C,S] pairs, comprising the steps of providing a table of entries [C,Se] and corresponding replacements [C,St], said table entries including one or more [C,S] pairs and said table replacements including one or more [C,St] replacement pairs, scanning said stream of [C,S] pairs for table entries, replacing one or more [C,S] pairs in said stream by a table replacement if a match is found between a table entry and one or more [C,S] pairs in said stream.

8. Method according to claim 7, wherein said table is provided with one or more table entries comprising a combination of at least one table replacement pair [C,St] and a [C,S] pair and corresponding replacements [C,St], wherein said stream of [C,S] pairs with replacements is scanned for further table entries.

9. Method according to claim 7 or 8, wherein said table is provided with one or more table entries comprising a combination of a [C,S] pair and a [Ca,Cb] pair and a corresponding replacement [C,St], said [Ca,Cb] pair instructing to replace a next context (Ca) by (Cb).

10. Method for processing a stream of symbols (S, St), comprising the steps of providing a table of entries [C,S] and corresponding replacements [C,St], said table entries including one or more [C,S] pairs and said table replacements including one or more [C,St] replacement pairs, providing a sequence of contexts (C), scanning said stream of symbols (S,St) in accordance with the sequence of contexts (C) and replacing a symbol(St) by the corresponding symbol(s) (S) of the corresponding table entry.

11. Method according to claim 10, wherein the sequence of contexts (C) is used to address a number of memories, each memory corresponding with a predetermined context (C), wherein for each context of said sequence the corresponding memory is read, wherein a) if a symbol is not available from the corresponding memory, a next symbol is read from the stream of symbols and loaded into the corresponding memory, b) if a symbol (S) is available in the corresponding memory, said symbol is inserted delivered to a symbol output, and c) if a symbol (St) is available in the corresponding memory, the table is read tar the corresponding table entry and the symbol(s) (S) of this entry are loaded in the memories in accordance with the corresponding context(s) of said entry.

12. Method according to claim 11, wherein, if a context (Cb) is available in the memory read as addressed by a context (C), a symbol is read from the stream of symbols (S) and loaded into the same memory.

13. Method for compressing and decompressing data, comprising the steps of modeling the data to obtain a stream of [C,S] pairs, coding [C,S] pairs to obtain compressed data, providing a table of entries [C,Se] and corresponding replacements [C,St], said table entries including one or more [C,Se] pairs and said table replacements including one or more [C,St] replacement pairs, processing the stream of [C,S] pairs provided by said modeling step by scanning said stream for table entries, replacing one or more [C,S] pairs in said stream by a table replacement pair if a match is found between a table entry and one or more [C,S} pairs in said stream, wherein said coding step is carried out on the processed stream of [C,S] pairs, decoding the compressed data to obtain a stream of symbols (S,St), generating a sequence of contexts (C) corresponding to the sequence of contexts provided by said modeling step, providing decoded symbols in accordance with the sequence of contexts, scanning the decoded symbols for table replacement symbols (St) and replacing a table replacement symbol (St) by the symbol(s) (S) of the corresponding table entry.

14. Method according to claim 13, wherein said table is provided with one or more table entries comprising a combination of at least one table replacement pair [C,St] and a [C,S] pair and corresponding replacements [C,St], wherein said stream of [C,S] pairs with replacements is scanned for further table entries.

15. Method according to claim 13 or 14, wherein said table is provided with one or more table entries comprising a combination of a [C,S] pair and a [Ca,Cb] pair and a corresponding replacement [C,St], said [Ca,Cb] pair instructing to replace a next context (Ca) by (Cb).

16. Method according to claim 13, 14 or 15, wherein position information is generated for each replacement made in the stream of [C,S] pairs, wherein a symbol (St) is replaced by the correponding symbol(s) (S) at a location in the stream of symbols as indicated by said position information.

17. Method according to claim 13, 14 or 15, wherein the sequence of contexts (C) is used to address a number of memories, each memory corresponding with a predetermined context (C), wherein for each context of said sequence the corresponding memory is read, wherein
a) if a symbol is not available from the corresponding memory, a next symbol is read from the stream of symbols and loaded into the corresponding memory,
b) if a symbol (S) is available in the corresponding memory, said symbol is inserted delivered to a symbol output, and
c) if a symbol (St) is available in the corresponding memory, the table is read for the corresponding table entry and the symbol(s) (S) of this entry are loaded in the memories in accordance with the corresponding context(s) of said entry.

18. Method according to claim 17, wherein, if a context (Cb) is available in the memory read as addressed by a context (C), a symbol is read from the stream of symbols (S) and loaded into the same memory.
